# EUROPEAN PATENT APPLICATION

(11) **EP 4 851 642 A1**
(43) Date of publication of application: **09.12.2026**
(21) Application number: 25181136.0
(22) Date of filing: 05.06.2025
(51) Int. Cl.: G01R 31/26

(54) **PARAMETER PREDICTION AND RELIABILITY ASSESSMENT FOR A SEMICONDUCTOR DEVICE**

(71) Applicant: VOLVO CAR CORPORATION, 405 31 Göteborg (SE)
(72) Inventor: ZHANG, Chi, 443 44 GRÅBO (SE)
(74) Representative: Kransell & Wennborg KB

(57) **Abstract**

A training method for a prediction module of a semiconductor device, a reliability assessment method, a control unit for a vehicle, and a vehicle are provided. The training method includes: acquiring a measured value of a state parameter of the semiconductor device, obtained by measuring the state parameter at a first moment and with a measurement cycle; acquiring a predicted value of the state parameter of the semiconductor device at the first moment generated by a prediction model based on a model dataset, wherein the model dataset comprises a plurality of historical measured values of the state parameter of the semiconductor device obtained with one or more measurement cycles; calculating an error between the measured value and the predicted value at the first moment; and training the prediction model based on the error.

## Description

### TECHNICAL FIELD

The present disclosure relates to a field of semiconductor devices, and in particular, to a training method for a prediction module of a semiconductor device, a reliability assessment method for a semiconductor device, a control unit for a vehicle, and a vehicle.

### BACKGROUND

Semiconductor devices, such as diodes and transistors, are core components of modern electronic devices and are widely used in integrated circuits, significantly driving the development of electronic technology. For example, diodes with unidirectional conductivity may be employed for rectification and demodulation; transistors, capable of achieving current amplification or switching functions, are often regarded as the "heart" of electronic circuits. In particular, in the automotive manufacturing field, Silicon Carbide (SiC) Metal-Oxide-Semiconductor Field-Effect Transistors (MOSFETs) are increasingly being used in automotive power electronic devices due to their high efficiency, fast switching, and superior thermal performance.

The reliability of semiconductor devices is crucial for ensuring stable operation of electronic devices. However, many factors, such as material defects, manufacturing processes, working environments (including temperature, humidity, voltage, etc.), and the like, can affect the reliability of semiconductor devices, for example, causing threshold voltage drift or increased leakage current, which in turn affect the normal operation of the devices. At present, the existing reliability assessment methods for semiconductor devices are less satisfactory. Thus, there is a need to develop more efficient and accurate reliability assessment methods to enhance the reliability of semiconductor devices and the overall performance of electronic devices.

### SUMMARY OF THE DISCLOSURE

The present disclosure proposes a training method for a prediction module of a semiconductor device and a reliability assessment method for a semiconductor device utilizing the trained prediction model, which can capture long-term and cumulative effects of the semiconductor device with less testing time, thereby realizing efficient and accurate reliability assessment of the semiconductor device as well as associated electronic devices.

According to one or more aspects of the present disclosure, there is provided a training method for a prediction model of a semiconductor device, comprising: acquiring a measured value of a state parameter of the semiconductor device, obtained by measuring the state parameter at a first moment and with a measurement cycle; acquiring a predicted value of the state parameter of the semiconductor device at the first moment generated by a prediction model based on a model dataset, wherein the model dataset comprises a plurality of historical measured values of the state parameter of the semiconductor device obtained with one or more measurement cycles; calculating an error between the measured value and the predicted value at the first moment; and training the prediction model based on the error.

According to one or more aspects of the present disclosure, there is provided a reliability assessment method for a semiconductor device, comprising: generating one or more predicted values of a state parameter of the semiconductor device at one or more moments by using a prediction model; and assessing reliability of the semiconductor device based on the one or more predicted values, wherein the prediction model is trained using the training method of the aforementioned aspects.

According to one or more aspects of the present disclosure, there is provided a control unit for a vehicle configured to perform the methods of the aforementioned aspects.

According to one or more aspects of the present disclosure, there is provided a vehicle comprising the control unit of the aforementioned aspects.

### BRIEF DESCRIPTION OF THE DRAWINGS

The above and other objects, features and advantages of embodiments of the present disclosure will become obvious from the following detailed description of embodiments of the present disclosure taken in conjunction with accompanying drawings. The accompanying drawings are used to provide further understanding of the embodiments of the present disclosure, constitute a part of the specification, explain the present disclosure together with the embodiments of the present disclosure, and do not constitute a limitation of the present disclosure. In the drawings, like reference numerals generally represent like components or steps.
FIG. 1 illustrates a flow chart of a training method for a prediction model of a semiconductor device according to one or more embodiments of the present disclosure.
FIG. 2 illustrates a measurement cycle for a threshold voltage of a semiconductor device according to an example of the present disclosure.
FIG. 3 illustrates variations in the threshold voltage and the measurement cycle over time according to an example of one or more embodiments of the present disclosure.
FIG. 4 illustrates a training process of the prediction model according to one or more embodiments of the present disclosure.
FIG. 5 illustrates a reliability assessment method for a semiconductor device according to one or more embodiments of the present disclosure.
FIG. 6 illustrates a schematic diagram of a control unit for a vehicle according to one or more embodiments of the present disclosure.

### DESCRIPTION OF THE EMBODIMENTS

In order to make objectives, technical solutions and advantages of the embodiments of the present disclosure clearer, the technical solutions in the embodiments of the present disclosure will be described clearly and thoroughly with reference to the accompanying drawings. Obviously, these described embodiments are only a part of the embodiments of the present disclosure, not all of the embodiments. All other embodiments obtained by those of ordinary skill in the art based on the embodiments in the present disclosure without paying creative efforts fall within the protection scope of the present disclosure.

As used herein and in the claims, the words "a", "an", "one", and/or "the" do not refer to the singular, but may include the plural unless the context clearly dictates otherwise. In general, the terms "comprise" and "include" only imply the inclusion of steps and elements specifically identified, these steps and elements do not constitute an exclusive list and a method or apparatus may also contain other steps or elements.

Flowcharts are used herein to illustrate steps of a method according to one or more embodiments of the present disclosure. It should be understood that preceding or subsequent steps do not have to be performed exactly in order. Rather, various steps may be processed in reverse order or simultaneously, as desired. Meanwhile, other steps may also be added to the method, or certain step or steps may be removed from the method.

As used herein and in the claims, a "semiconductor device" refers to an electronic component manufactured by exploiting the unique electrical properties of semiconductor materials, such as silicon, germanium, and the like. These devices encompass a wide range of components, including but not limited to diodes, transistors, and integrated circuits that integrate multiple semiconductor devices. In particular, a "transistor" refers to a semiconductor device with functions such as amplification and switching. Depending on their structure and operating principles, transistors may be categorized into Bipolar Junction Transistors (BJTs) and Field-Effect Transistors (FETs), in which FETs may include, but are not limited to, Junction Field-Effect Transistors (JFETs), Metal-Oxide-Semiconductor Field-Effect Transistors (MOSFETs), and the like. Hereinafter, a transistor (e.g., MOSFET) may often be used as an example for description of the proposed methods, which are for illustrative purposes only without limiting the present disclosure in any aspect. It should be appreciated that the proposed methods may be equally applicable to any other semiconductor devices, unless explicitly stated otherwise or there exists a clear contradiction.

The reliability of gate oxide is a key factor affecting the performance and lifespan of semiconductor devices, especially FETs such as MOSFETs. In prior art, static gate stress testing may be used to evaluate the long-term degradation of semiconductor devices under constant voltage. For example, static gate stress testing may include Time-Dependent Dielectric Breakdown (TDDB), which measures oxide failure under constant direct current (DC) stress, and Bias Temperature Instability (BTI), which assesses threshold voltage drift under prolonged DC gate stress.

However, static gate stress testing fails to capture the performance variations of semiconductor devices under real-world operating conditions. In practical applications, for example, semiconductor devices (e.g., SiC MOSFETs) are subjected to dynamic conditions like rapid voltage transients, high-frequency switching, and repetitive gate stress cycles due to factors such as pulse-width modulation (PWM). These dynamic conditions may induce charge trapping, oxide degradation, threshold voltage shifts, and the like, thereby significantly impacting device lifespan. Static gate stress testing such as TDDB and BTI are not fully capable of capturing these dynamic effects.

Consequently, Dynamic Gate Stress (DGS) testing is essential for evaluating the performance and degradation of semiconductor devices under real-world applications. Double Pulse Testing (DPT) is a dynamic testing method that can characterize switching characteristics, but it primarily focuses on energy loss rather than long-term degradation. Simplified metrics such as threshold voltage (V_{TH}) shift or leakage current increase are commonly used for DGS testing. However, these metrics fail to fully capture the long-term, cumulative effects of repetitive stress cycles, such as progressive oxide thinning and defect growth. Therefore, there is a need for a more efficient and accurate DGS testing method.

In recent years, Artificial Intelligence (AI) has been developing rapidly and has been widely applied in various fields. The present disclosure proposes an AI-based DGS testing method for semiconductor devices. This method can accurately capture the long-term, cumulative effects generated by repeated stress cycles, and achieve long-term prediction of state parameters of semiconductor devices while significantly reducing the physical testing time, thereby precisely learning the characteristics of changes in these parameters.

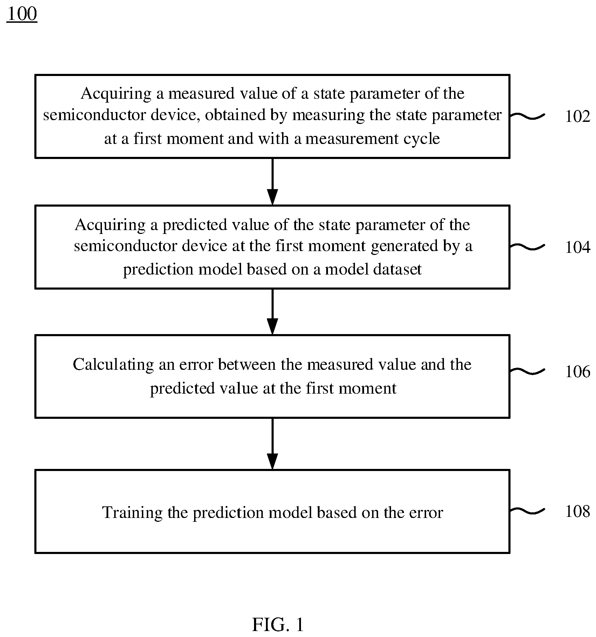

FIG. 1 illustrates a flow chart of a training method 100 for a prediction model of a semiconductor device according to one or more embodiments of the present disclosure. As mentioned earlier, the semiconductor device may be a diode, a transistor, an integrated circuit that integrates multiple semiconductor devices, and the like. In particular, the semiconductor device may be a FET or a MOSFET, such as a SiC MOSFET.

Herein, the prediction model may be specifically designed and trained to predict future values of a state parameter of the semiconductor device. These predicted values are crucial for conducting a comprehensive reliability assessment of the device. Specifically, the prediction model may be a neural network model with time series prediction capability, including but not limited to Long Short-Term Memory (LSTM), Gated Recurrent Unit (GRU), Temporal Convolutional Networks (TCN), a transformer-based model, and the like. Among these options, an LSTM-based prediction model is particularly well-suited for the reliability assessment of semiconductor devices. LSTM is a specialized type of Recurrent Neural Network (RNN) architecture that excels in learning order-dependence in sequence-prediction problems. Its unique structure allows it to effectively capture long-term dependencies and temporal patterns in the measured state parameter values, making it highly effective for predicting future state parameter values of the semiconductor device based on historical measured values.

Herein, the state parameter of a semiconductor device may refer to a parameter that represents operational and physical conditions of the semiconductor device, and reflects the device's performance, stability, and degradation over time. For example, state parameters of a semiconductor device may include, but are not limited to, threshold voltage, leakage current, on-state resistance, on-state voltage, thermal resistance, heat capacity, reverse recovery charge of body diode, on-state voltage of body diode, voltage change rate during turn-off, peak voltage during turn-off, junction temperature of the semiconductor device, and the like.

Hereinafter, the threshold voltage (V_{TH}) may be taken as an example for description, which is for illustrative purposes only and is not intended to limit the present disclosure. The threshold voltage is a critical parameter in semiconductor devices, particularly in FETs such as MOSFETs. It is defined as the minimum gate-to-source voltage (V_{GS}) required to create a conducting path between the source and drain terminals, thereby turning the transistor on. In other words, the threshold voltage is a voltage level at which the device transitions from the off-state to the on-state.

As shown in FIG. 1, in step 102, a measured value of a state parameter of the semiconductor device may be acquired. The measured value may be obtained by measuring the state parameter at a first moment and with a measurement cycle. Herein, the measurement cycle of a state parameter of the semiconductor device may refer to an interval or procedure used to periodically assess the state parameter of the device, or in other words, a time required to obtain one measurement of the state parameter. Usually, a specific measurement cycle may vary depending on a type of the device, a testing standard, application requirements, and the like. For example, JEDEC JEP183 is a standard that provides detailed guidelines for measuring the threshold voltage of SiC MOSFETs, including a definition of the measurement cycle.

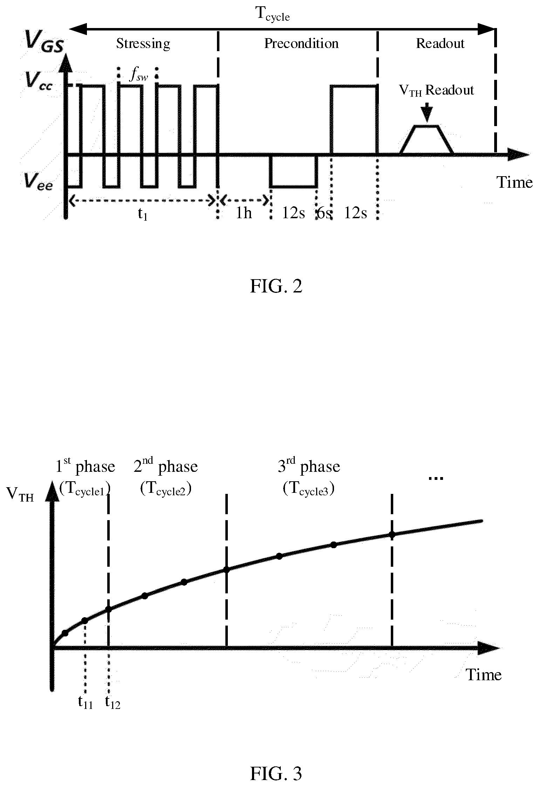

FIG. 2 illustrates a measurement cycle for a threshold voltage of a semiconductor device according to an example of the present disclosure, in which the measurement cycle conforms to JEDEC JEP183. In the example of FIG. 2, a typical measurement cycle of the threshold voltage may include a stressing stage, a precondition stage, and a readout stage. During the stressing stage, a rectangular Alternating Current (AC) stress (e.g., voltage from a minimum value Vₑₑ to a maximum value V_{cc}) with a predefined frequency, *f_{sw},* is applied to the semiconductor device (e.g., SiC MOSFET) as the gate-to-source voltage (V_{GS}). The predefined frequency may be changed to apply different stress on the gate of the device. A duration of the stressing stage (shown as t₁) may be adjusted to achieve a different aging period and thus a different measurement cycle. For example, the AC stress may be an operational voltage of the SiC stress under practical application conditions, such as during operation of an automotive vehicle. A drift of the threshold voltage may be introduced in the device during the stressing stage.

During the precondition stage, an irregular stress (e.g., voltage) may be applied to the device to eliminate some recoverable drifts of the threshold voltage. For example, according to the JEP183 standard, V_{GS} will be kept to 0V for 1h, Vee for 12s, 0V for 6s, and Vcc for 12s in a sequenced way. Then, during the readout stage, the measured value of the threshold voltage may be read, for example, according to the JEP183 standard. The total time of the three stages may be defined as the measurement cycle (T_{cycle}). Since the duration of the stressing stage may be changed, the measurement cycle is adjustable. The adjustable measurement cycle may contribute to a sliding window feature of the prediction model proposed by the present disclosure, as will be described in further detail below.

Return to FIG. 1, in Step 104, a predicted value of the state parameter of the semiconductor device at the first moment may be generated by the prediction model based on a model dataset. The model dataset may include a plurality of historical measured values of the state parameter of the semiconductor device obtained with one or more measurement cycles. The prediction model may be pre-trained on the model dataset and thus can generate the predicted value of the state parameter at the first moment.

For an LSTM-based prediction model, how much time ahead the prediction model can predict the state parameter value strongly depends on the number of data in the model dataset input to the prediction model and a step size of the data. By way of example rather than limitation, if the model dataset includes N measured values of the state parameter obtained with the same measurement cycle, T_{cycle}, that is, the step size of the measured values is T_{cycle}, the prediction module can generate a predicted value of the state parameter by N*T_{cycle} ahead.

Herein, how much time ahead the prediction model can predict the state parameter value may be referred to as a lead time. Generally, the predication module is expected to have a large lead time, thereby enabling capture of long-term variations in the state parameter of the semiconductor device. The large expected lead time requires a large measurement cycle and/or a large number of measured values in the model dataset. Meanwhile, to capture the initial linear characteristics of the state parameter (e.g., the threshold voltage), the measurement cycle may initially be set relatively short and then gradually increased over time.

FIG. 3 illustrates variations in the threshold voltage and the measurement cycle over time according to an example of one or more embodiments of the present disclosure. As shown in FIG. 3, the threshold voltage of the device increases gradually over time. In particular, during a first phase, a rate of change is relatively high and approximates a linear trend. Therefore, the measurement cycle may be set to a short duration during the first phase to capture such linear characteristics, denoted as T_{cycle1}. This measurement cycle may represent an interval between two consecutive measured threshold voltages, that is, T_{cycle1}=t₁₂-t₁₁.

A plurality of measured values of the state parameter may be obtained with the measurement cycle of the first phase (T_{cycle1}), and stored in the model dataset for pre-training of the prediction model. Thus, the pre-trained prediction model may generate the prediction value of the state parameter at the first moment based on the model dataset.

In step 106, an error between the measured value and the predicted value at the first moment may be calculated. Then, in step 108, the prediction model may be trained based on the error. In particular, the error may be compared with one or more error thresholds to determine whether the prediction model meets a required accuracy. Additionally, a lead time of the prediction model may be compared with the expected lead time to determine whether to terminate the training of the model.

According to one or more embodiments of the present disclosure, if the error is less than a first error threshold, indicating that the prediction model is accurate enough, and the prediction model has a lead time greater than or equal to an expected lead time, the training of the prediction model may be completed and the prediction model may be fixed. The lead time may indicate how much time ahead the prediction model can predict a value of the state parameter. As mentioned earlier, the lead time of the prediction model may be based on a total number of historical measured values included in the model dataset input into the prediction model and one or more measurement cycles corresponding to the historical measured values. The expected lead time may be predefined according to actual requirements, for example. The fixed prediction model may be used to predict future values of the state parameter of the semiconductor device for reliability assessment. Alternatively, the prediction model may be fine-tuned regularly with an updated model dataset including more measured values.

According to one or more embodiments of the present disclosure, if the error is less than a first error threshold but the lead time of the prediction model is less than the expected lead time, the training of the prediction model may be continued. Specifically, the measurement cycle may be increased, for example, to the cycle of the second phase (T_{cycle2}) as shown in FIG. 3. The measurement cycle may be increased linearly or nonlinearly, or according to a specific function or curve, such as the curve of FIG. 3. In addition, the measured value of the state parameter at the first moment may be stored in the model dataset to generate an updated model dataset.

Then, steps 102-108 may be repeated using measured and predicted values at a second moment. Specifically, a measured value of the state parameter of the semiconductor device may be acquired, wherein the measured value is obtained by measuring the state parameter at the second moment using the increased measurement cycle (e.g., T_{cycle2}). A predicted value of the state parameter at the second moment may be generated by the prediction model based on the updated model dataset. Then, an updated error is calculated between the measured value and the predicted value at the second moment. Based on the updated error, whether to complete or continue the training of the prediction model may be determined.

Similarly, if the updated error is less than the first error threshold and the lead time of the prediction model is greater than or equal to the expected lead time, the training of the prediction may be completed. For example, if the model dataset includes N measured values obtained with a measurement cycle of T_{cycle1} and M (e.g., equal to 1 at the second moment) measured values obtained with a measurement cycle of T_{cycle2}, the lead time may be estimated as N* T_{cycle1}+M* T_{cycle2} and compared with the expected lead time. Otherwise, the training of the prediction may be continued. In particular, if the updated error is less than the first error threshold but the lead time of the prediction model is less than the expected lead time, the measurement cycle may be further increased, for example, to the cycle of the third phase (T_{cycle3}) as shown in FIG. 3.

By increasing the measurement cycle, i.e., the step size of the model dataset, the lead time of the prediction model may be increased. As a result, the model can predict data over a more extended range, thereby significantly reducing practical testing time required for the reliability assessment of semiconductor devices. Furthermore, a larger measurement cycle, i.e., a larger step size, results in fewer measured values in the model dataset, which may reduce the complexity of the prediction model and make it more suitable for deployment in lightweight systems, such as a micro controller unit of a vehicle.

Return to 108 of FIG. 1, according to one or more embodiments of the present disclosure, if the error between the measured value and the predicted value at the first moment is greater than the first error threshold, the training of the prediction model may be continued. Specifically, the error may be further compared with a second error threshold greater than the first error threshold, and the training of the prediction model may be continued based on the comparison between the error and the second error threshold.

Specifically, if the error between the measured value and the predicted value at the first moment is greater than the first error threshold and less than the second error threshold, indicating that the prediction model is within certain accuracy, the number of values in the model dataset (or called the dataset size) may be increased to further improve the prediction accuracy. However, the measurement cycle will remain unchanged. The measured value at the first moment may be stored in the model dataset, to generate an updated model dataset for continuing training. While an increased number of measure values compared to an increased measurement cycle (step size) may require more iterative loops and thus more computational complexity of the model, it can extend the lead time of prediction.

Otherwise, if the error is greater than the second error threshold, indicating that the model's prediction based on the current model dataset is unsatisfactory and requires additional training, then no action for increasing the prediction lead time will be taken, including neither increasing the measurement cycle nor expanding the dataset size. That is, a current size of the model dataset may be maintained for subsequent training. As a result, the measured value at the first moment may be stored in the model dataset, while an earliest measured value in the model dataset may be discarded, to generate an updated model dataset for continuing training.

Similarly, steps 102-108 may be repeated based on the updated dataset. Specifically, a measured value of the state parameter of the semiconductor device may be acquired, wherein the measured value is obtained by measuring the state parameter at the second moment and with the initial measurement cycle (e.g., T_{cycle1}). A predicted value of the state parameter at the second moment may be generated by the prediction model based on the updated model dataset. Then, an updated error is calculated between the measured value and the predicted value at the second moment. Based on the updated error, whether to complete or continue the training of the prediction model may be determined. Similarly, if the updated error is less than the first error threshold and the lead time of the prediction model is greater than or equal to the expected lead time, the training of the prediction may be completed. Otherwise, the training of the prediction may be continued.

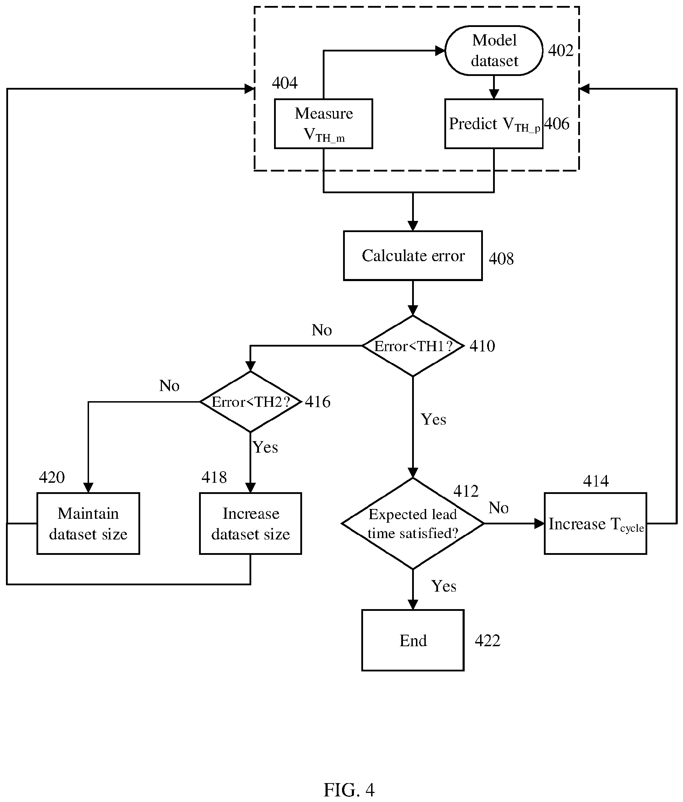

To facilitate comprehension, FIG. 4 illustrates a training process of the prediction model according to one or more embodiments of the present disclosure. As shown in FIG. 4, a value of the state parameter at a first moment may be obtained with an initial measurement cycle at 404 (V_{TH_m}), which will be stored in the model dataset 402 together with historical measured values. At 406, the prediction model may predict the value of the state parameter at the first moment (V_{TH_p}) based on the model dataset 402. At 408, the error between the measured value and the predicted value at the first moment may be calculated. At 410, the error may be compared with the first error threshold (TH1). If the error is less than TH1, at 412, it may be further decided whether the expected lead time is satisfied, that is, whether the lead time of the prediction model is greater than or equal to the expected lead time. If yes, the training of the prediction model may be completed at 422. Otherwise, if the expected lead time is not satisfied, the measurement cycle may be increased at 414 and the process returns to steps 402-406 for continuing training.

On the other hand, if it is determined that the error is larger than TH1 at 410, the training will be continued. At 416, the error may be further compared with the second error threshold (TH2) larger than TH1. At 418, if the error is greater than TH1 and less than TH2, it is allowed to add more measured values to the model dataset to expand its size, thereby enhancing training as well as increasing the prediction lead time of the model. Otherwise, at 420, if the error is greater than TH2, indicating that the model's prediction based on the current model dataset is unsatisfactory and requires additional training, no action for increasing the lead time of prediction will be taken, including neither increasing the measurement cycle nor expanding the dataset size. In this case, the current dataset size will be maintained by adding the measured value at the first moment to the model dataset and discarding the earliest measured value. In both cases of 418 and 420, the process returns to steps 402-406 for continuing training while maintaining the measurement cycle unchanged.

The training method for the prediction model of a semiconductor device has been described above with reference to FIGS. 1-4. The prediction model may be trained using a sliding window approach with gradually increasing measurement cycles, thereby extending the prediction lead time and reducing the need for physical testing. The trained prediction model is capable of capturing a long-term, cumulative effects of repetitive stress cycles on the semiconductor device, and can accurately learn the non-linear behavior of the state parameter (e.g., the threshold voltage).

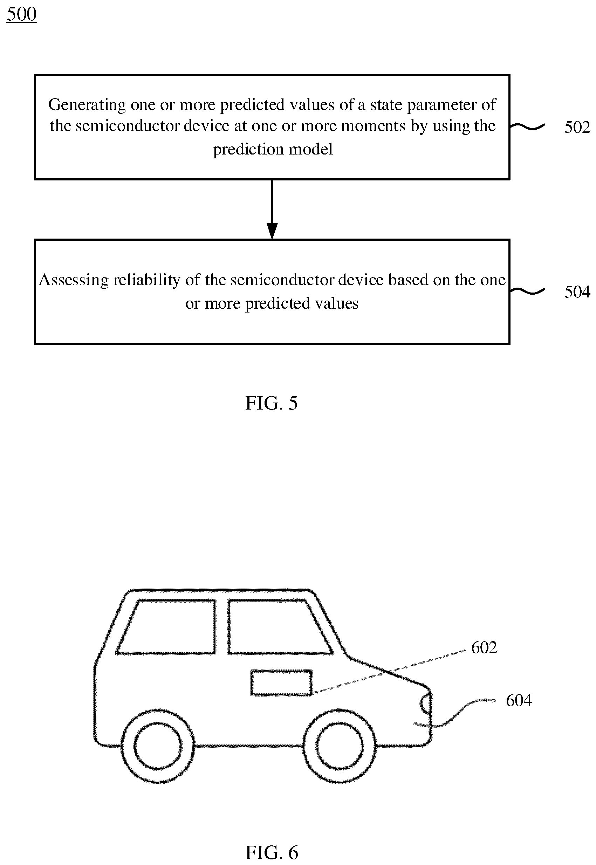

FIG. 5 illustrates a reliability assessment method 500 for a semiconductor device according to one or more embodiments of the present disclosure. As shown in FIG. 5, in step 502, one or more predicted values of a state parameter of the semiconductor device at one or more moments may be generated by using the prediction model as described above with reference to FIGS. 1-4. Then in step 504, the reliability of the semiconductor device may be assessed based on the one or more predicted values. For example, if a predicted value (e.g., a leakage current) or a drift of the predicted value (e.g., a threshold voltage drift) is less than a predetermined threshold, it may be determined that the reliability of the semiconductor device is high. Otherwise, if a predicted value (e.g., a leakage current) or a drift of the predicted value (e.g., a threshold voltage drift) is greater than the predetermined threshold, it may be determined that the reliability of the semiconductor device is low. Accordingly, an expected service life of the device or possible maintenance advice may be provided.

Compared to traditional reliability assessment methods, the AI prediction model-based reliability assessment method proposed by the present disclosure can predict the long-term stress effects on semiconductor devices while substantially reducing the required physical testing time. This approach not only enables more efficient monitoring of semiconductor device reliability but also offers enhanced assurance of stability for the semiconductor devices and their associated components.

According to one or more embodiments of the present disclosure, a control unit for a vehicle is provided. FIG. 6 illustrates a schematic diagram of a control unit 602 for a vehicle according to one or more embodiments of the present disclosure. The control unit 602 may be configured to perform any of the steps of the training method for the prediction model of a semiconductor device described above with reference to FIGS. 1-4, and any of the steps of the reliability assessment method for a semiconductor device described above with reference to FIG. 5. For the sake of brevity, details of some functions of the control unit 602 are omitted herein.

In particular, the control unit 602 may be configured to acquire a measured value of a state parameter of the semiconductor device, obtained by measuring the state parameter at a first moment and with a measurement cycle; acquire a predicted value of the state parameter of the semiconductor device at the first moment generated by a prediction model based on a model dataset, wherein the model dataset comprises a plurality of historical measured values of the state parameter of the semiconductor device obtained with one or more measurement cycles; calculate an error between the measured value and the predicted value at the first moment; and train the prediction model based on the error.

The control unit 602 may be further configured to generate one or more predicted values of a state parameter of the semiconductor device at one or more moments by using the prediction model as described above with reference to FIGS. 1-4; and assess reliability of the semiconductor device based on the one or more predicted values.

According to one or more embodiments of the present disclosure, a vehicle comprising the control unit 602 is provided, such as the vehicle 604 shown in FIG. 6. As used herein, the term "vehicle" refers to a thing used for transporting people or goods. Automobiles, cars, trucks, or buses, etc. are examples of vehicles. The term "vehicle" also includes electric vehicle (EV) powered by an electric motor that draws current from an on-vehicle energy storage device, such as a battery, which is rechargeable from an off-vehicle source, such as residential or public electric service or an on-vehicle fuel-powered generator. The EV may be two or more wheeled vehicles manufactured for use primarily on public streets, and roads. The EV may be referred to as an electric car, an electric automobile, an electric road vehicle (ERV), a plug-in vehicle (PV), a plug-in vehicle (xEV), etc., and the xEV may be classified into a plug-in all-electric vehicle (BEV), a battery electric vehicle, a plug-in electric vehicle (PEV), a hybrid electric vehicle (HEV), a hybrid plug-in electric vehicle (HPEV), a plug-in hybrid electric vehicle (PHEV), etc.

The following is a non-limiting list of examples that are in accordance with one or more techniques of this disclosure.

Example 1. A training method for a prediction model of a semiconductor device, comprising: acquiring (102) a measured value of a state parameter of the semiconductor device, obtained by measuring (404) the state parameter at a first moment and with a measurement cycle; acquiring (104) a predicted value of the state parameter of the semiconductor device at the first moment generated (406) by a prediction model based on a model dataset (402), wherein the model dataset (402) comprises a plurality of historical measured values of the state parameter of the semiconductor device obtained with one or more measurement cycles; calculating (106, 408) an error between the measured value and the predicted value at the first moment; and training (108) the prediction model based on the error.

Example 2. The method of Example 1, wherein training the prediction model based on the error comprises: completing (422) the training of the prediction model if the error is less than a first error threshold (410) and the prediction model has a lead time greater than or equal to an expected lead time (412), the lead time indicating how much time ahead the prediction model can predict a value of the state parameter.

Example 3. The method of any of Examples 1-2, wherein training the prediction model based on the error comprises: continuing the training of the prediction model if the error is less than the first error threshold and the lead time of the prediction model is less than the expected lead time.

Example 4. The method of any of Examples 1-3, wherein continuing the training of the prediction model comprises: increasing (414) the measurement cycle and storing the measured value at the first moment in the model dataset (402) to generate an updated model dataset (402); acquiring a measured value of the state parameter, obtained by measuring (404) the state parameter at a second moment and with the increased measurement cycle; acquiring a predicted value of the state parameter at the second moment generated (406) by the prediction model based on the updated model dataset (402); calculating (408) an updated error between the measured value and the predicted value at the second moment; and training the prediction model based on the updated error.

Example 5. The method of any of Examples 1-4, wherein the measurement cycle is increased linearly or nonlinearly.

Example 6. The method of any of Examples 1-5, wherein a lead time of the prediction model is based on a total number of historical measured values included in the model dataset (402) input into the prediction model and one or more measurement cycles corresponding to the historical measured values.

Example 7. The method of any of Examples 1-6, wherein training the prediction model based on the error comprises: comparing (416) the error with a second error threshold if the error is greater than the first error threshold, the second error threshold being greater than the first error threshold; and continuing the training of the prediction model based on the comparison between the error and the second error threshold.

Example 8. The method of any of Examples 1-7, wherein: if the error is greater than the first error threshold and less than the second error threshold, storing the measured value at the first moment in the model dataset (402) to generate an updated model dataset (402), and if the error is greater than the second error threshold, storing the measured value at the first moment in the model dataset (402) and removing an earliest measured value from the model dataset (402) to generate an updated model data set (402).

Example 9. The method of any of Examples 1-8, wherein continuing the training of the prediction model comprises: acquiring a measured value of the state parameter, obtained by measuring (404) the state parameter at a second moment and with the measurement cycle; acquiring a predicted value of the state parameter at the second moment generated (406) by the prediction model based on the updated model dataset (402); calculating (408) an updated error between the measured value and the predicted value at the second moment; and training the prediction model based on the updated error.

Example 10. The method of any of Examples 1-9, wherein the measurement cycle comprises a stressing stage, a precondition stage, and a readout stage, and the measured value of the state parameter is obtained by: applying an alternating stress to the semiconductor device in the stressing stage; applying an irregular stress to the semiconductor device in the precondition stage; and reading the measured value of the state parameter of the semiconductor device in the readout stage, wherein the measurement cycle is adjustable by changing a duration of the stressing stage.

Example 11. The method of any of Examples 1-10, wherein the state parameter comprises one or more of threshold voltage, leakage current, on-state resistance, on-state voltage, thermal resistance, heat capacity, reverse recovery charge of body diode, on-state voltage of body diode, voltage change rate during turn-off, peak voltage during turn-off, and junction temperature of the semiconductor device.

Example 12. The method of any of Examples 1-11, wherein the semiconductor device is a transistor and the prediction model is a neural network model with time series prediction capability.

Example 13. A reliability assessment method for a semiconductor device, comprising: generating (502) one or more predicted values of a state parameter of the semiconductor device at one or more moments by using a prediction model; and assessing (504) reliability of the semiconductor device based on the one or more predicted values, wherein the prediction model is trained using the method of any of Examples 1-12.

Example 14. A control unit (602) for a vehicle configured to perform the method of any of Examples 1-12.

Example 15. A vehicle (604) comprising the control unit of Example 14.

It is to be recognized that depending on the examples, certain acts or events of any of the techniques described herein can be performed in a different sequence, may be added, merged, or left out altogether (e.g., not all described acts or events are necessary for the practice of the techniques). Moreover, in certain examples, acts or events may be performed concurrently, e.g., through multi-threaded processing, interrupt processing, or multiple processors, rather than sequentially.

Program portions of the technology may be considered to be "product" or "article" that exists in the form of executable codes and/or related data, which are embodied or implemented by a computer-readable medium. A tangible, permanent storage medium may include an internal memory, or a storage used by computers, processors, or similar devices or associated modules. For example, various semiconductor memories, tape drivers, disk drivers, or any similar devices capable of providing storage functionality for software.

All software or parts of it may sometimes communicate over a network, such as the Internet or other communication networks. Such communication can load software from one computer device or processor to another. For example, loading from one server or host computer to a hardware environment of one computer environment, or other computer environment implementing the system, or a system having a similar function associated with providing information needed for the communication method. Therefore, another medium capable of transmitting software elements can also be used as a physical connection between local devices, such as light waves, electric waves, electromagnetic waves, etc., to be propagated through cables, optical cables, or air. A physical medium used for carrying the waves such as cables, wireless connections, or fiber optic cables may also be considered as a medium for carrying the software. In usage herein, unless a tangible "storage" medium is defined, other terms referring to a computer or machine "readable medium" mean a medium that participates in execution of any instruction by the processor.

The present application uses specific words to describe embodiments of the present disclosure. Reference to "an embodiment," "one or more embodiments," and/or "some embodiments" means a feature, structure, or characteristic in connection with at least one embodiment of the present disclosure. Therefore, it should be emphasized and noted that two or more references to "an embodiment," "one embodiment," or "an alternative embodiment" in various places throughout this specification do not necessarily refer to the same embodiment. Furthermore, certain features, structures, or characteristics may be combined as suitable in one or more embodiments of the application.

Moreover, one skilled in the art will appreciate that aspects of the present disclosure may be illustrated and described in terms of a number of patentable categories or instances, including any new and useful process, machine, manufacture, or combination of matter, or any new and useful improvement thereof. Accordingly, aspects of the present disclosure may be performed entirely by hardware, entirely by software (including firmware, resident software, micro-code, etc.), or by a combination of hardware and software. The above hardware or software may each be referred to as a "data block," "module," "engine," "unit," "component," or "system." Furthermore, aspects of the present disclosure may be embodied as a computer product embodied in one or more computer-readable media including computer-readable program code.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or extremely formal sense unless expressly so defined herein.

While various embodiments of the disclosure have been described, it will be apparent to those of ordinary skill in the art that many more embodiments and implementations are possible that are within the scope of the disclosure. Accordingly, the disclosure is not to be restricted except in light of the attached claims and their equivalents.

## Claims

1. A training method for a prediction model of a semiconductor device, comprising:
acquiring (102) a measured value of a state parameter of the semiconductor device, obtained by measuring (404) the state parameter at a first moment and with a measurement cycle;
acquiring (104) a predicted value of the state parameter of the semiconductor device at the first moment generated (406) by a prediction model based on a model dataset (402), wherein the model dataset (402) comprises a plurality of historical measured values of the state parameter of the semiconductor device obtained with one or more measurement cycles;
calculating (106, 408) an error between the measured value and the predicted value at the first moment; and
training (108) the prediction model based on the error.

2. The method of claim 1, wherein training the prediction model based on the error comprises:
completing (422) the training of the prediction model if the error is less than a first error threshold (410) and the prediction model has a lead time greater than or equal to an expected lead time (412), the lead time indicating how much time ahead the prediction model can predict a value of the state parameter.

3. The method of claim 2, wherein training the prediction model based on the error comprises:
continuing the training of the prediction model if the error is less than the first error threshold and the lead time of the prediction model is less than the expected lead time.

4. The method of claim 3, wherein continuing the training of the prediction model comprises:
increasing (414) the measurement cycle and storing the measured value at the first moment in the model dataset (402) to generate an updated model dataset (402);
acquiring a measured value of the state parameter, obtained by measuring (404) the state parameter at a second moment and with the increased measurement cycle;
acquiring a predicted value of the state parameter at the second moment generated (406) by the prediction model based on the updated model dataset (402);
calculating (408) an updated error between the measured value and the predicted value at the second moment; and
training the prediction model based on the updated error.

5. The method of claim 4, wherein the measurement cycle is increased linearly or nonlinearly.

6. The method of any of claims 2-5, wherein a lead time of the prediction model is based on a total number of historical measured values included in the model dataset (402) input into the prediction model and one or more measurement cycles corresponding to the historical measured values.

7. The method of claim 2, wherein training the prediction model based on the error comprises:
comparing (416) the error with a second error threshold if the error is greater than the first error threshold, the second error threshold being greater than the first error threshold; and
continuing the training of the prediction model based on the comparison between the error and the second error threshold.

8. The method of claim 7, wherein:
if the error is greater than the first error threshold and less than the second error threshold, storing the measured value at the first moment in the model dataset (402) to generate an updated model dataset (402), and
if the error is greater than the second error threshold, storing the measured value at the first moment in the model dataset (402) and removing an earliest measured value from the model dataset (402) to generate an updated model data set (402).

9. The method of claim 8, wherein continuing the training of the prediction model comprises:
acquiring a measured value of the state parameter, obtained by measuring (404) the state parameter at a second moment and with the measurement cycle;
acquiring a predicted value of the state parameter at the second moment generated (406) by the prediction model based on the updated model dataset (402);
calculating (408) an updated error between the measured value and the predicted value at the second moment; and
training the prediction model based on the updated error.

10. The method of any of claims 1-9, wherein the measurement cycle comprises a stressing stage, a precondition stage, and a readout stage, and the measured value of the state parameter is obtained by:
applying an alternating stress to the semiconductor device in the stressing stage;
applying an irregular stress to the semiconductor device in the precondition stage; and
reading the measured value of the state parameter of the semiconductor device in the readout stage,
wherein the measurement cycle is adjustable by changing a duration of the stressing stage.

11. The method of any of claims 1-10, wherein the state parameter comprises one or more of threshold voltage, leakage current, on-state resistance, on-state voltage, thermal resistance, heat capacity, reverse recovery charge of body diode, on-state voltage of body diode, voltage change rate during turn-off, peak voltage during turn-off, and junction temperature of the semiconductor device.

12. The method of any of claims 1-11, wherein the semiconductor device is a transistor and the prediction model is a neural network model with time series prediction capability.

13. A reliability assessment method for a semiconductor device, comprising:
generating (502) one or more predicted values of a state parameter of the semiconductor device at one or more moments by using a prediction model; and
assessing (504) reliability of the semiconductor device based on the one or more predicted values,
wherein the prediction model is trained using the method of any of claims 1-12.

14. A control unit (602) for a vehicle configured to perform the method of any of claims 1-12.

15. A vehicle (604) comprising the control unit of claim 14.
